# EUROPEAN PATENT SPECIFICATION

(11) **EP 3 117 450 B1**
(45) Date of publication and mention of the grant of the patent: **08.01.2020**
(21) Application number: 15761791.1
(22) Date of filing: 05.03.2015
(51) Int. Cl.: H01L 21/304, C09G 1/02, C23F 3/06, H01L 21/321

(54) **COMPOSITIONS AND METHODS FOR CMP OF TUNGSTEN MATERIALS**
ZUSAMMENSETZUNGEN UND VERFAHREN FÜR CHEMISCH-MECHANISCHES POLIEREN VON WOLFRAMMATERIALIEN
COMPOSITION ET PROCÉDÉ POUR LE CMP DE MATÉRIAUX EN TUNGSTÈNE

(30) Priority: 12.03.2014 US 201461951670 P
(43) Date of publication of application: 18.01.2017
(73) Proprietor: Cabot Microelectronics Corporation, Aurora, Illinois 60504 (US)
(72) Inventor: LIN, Chih-An, Aurora, Illinois 60504 (US); CHEN, Zhan, Aurora, Illinois 60504 (US)
(74) Representative: Barker Brettell LLP
(86) International application number: PCT/US2015/018917
(87) International publication number: WO 2015/138209

(56) References cited:
- EP-A1- 0 896 042
- EP-A1- 1 717 285
- EP-A2- 2 357 059
- EP-A2- 2 357 059
- WO-A1-03/068883
- US-A1- 2004 244 911
- US-A1- 2009 117 829

## Description

### FIELD OF THE INVENTION

This invention relates to polishing compositions and methods. More particularly, this invention relates to chemical-mechanical polishing method suitable for polishing tungsten surfaces.

### BACKGROUND OF THE INVENTION

A semiconductor wafer typically includes a substrate, such as silicon or gallium arsenide, on which a variety of metal layers have been deposited. Tungsten (W) is used in a variety of semiconductor applications, including as a thin-film layer or as a tungsten plug to connect between multilevel interconnections.

In one common use of tungsten, metallized vias or contacts are formed by a blanket tungsten deposition followed by a chemical mechanical polishing (CMP) process. In a typical process, "via holes" are etched through an interlevel dielectric and a thin TiN adhesion layer is generally formed over the interlevel dielectric and into the via hole. Next, a tungsten film is deposited as a blanket over the adhesion layer and into the via. The deposition is continued until the via hole is completely filled with tungsten. The metal films formed on the top surface of the interlevel dielectric are then removed by chemical mechanical polishing, thereby forming metal vias or plugs.

Compositions and methods for CMP of the surface of a substrate are well known in the art. Polishing compositions (also known as polishing slurries, CMP slurries, and CMP compositions) for CMP of metal-containing surfaces of semiconductor substrates (e.g., integrated circuits) typically contain an abrasive, various additive compounds, and the like.

In conventional CMP techniques, a substrate carrier or polishing head is mounted on a carrier assembly and positioned in contact with a polishing pad in a CMP apparatus. The carrier assembly provides a controllable pressure to the substrate, urging the substrate against the polishing pad. The pad and carrier, with its attached substrate, are moved relative to one another. The relative movement of the pad and substrate serves to abrade the surface of the substrate to remove a portion of the material from the substrate surface, thereby polishing the substrate. The polishing of the substrate surface typically is further aided by the chemical activity of the polishing composition (e.g., by oxidizing agents or other additives present in the CMP composition) and/or the mechanical activity of an abrasive suspended in the polishing composition. Typical abrasive materials include silicon dioxide, cerium oxide, aluminum oxide, zirconium oxide, and titanium oxide.

The CMP process used to remove the tungsten layer can result undesirably in the formation of recesses in the tungsten layer or the tungsten plug. Tungsten recessing increases when over-polishing is used to ensure complete removal of the tungsten film across the surface of a wafer. Tungsten recessing leads to surface non-planarity which can compromise circuit integrity. Recessing also creates a variety of complications to the deposition of layers on subsequent levels of the device.

EP 2357059 A2 discloses method of chemical mechanical polishing of a substrate comprising tungsten, the method utilizes a polishing composition which includes a poly(alkyleneimine) such as polyethyleneimine, an abrasive, an acid, and an oxidizing agent, such as a per-compound. WO 03/068883 A1 describes chemical-mechanical polishing systems, and methods of polishing a substrate using the polishing systems, comprising (a) an abrasive, (b) a liquid carrier, and (c) a positively charged polyelectrolyte with a molecular weight of about 15,000 or more, wherein the abrasive comprises particles that are electrostatically associated with the positively charged polyelectrolyte.

There is an ongoing need for compositions and methods for CMP of tungsten-containing substrates that will reduce recessing of tungsten, while at the same time maintaining useful rates of tungsten removal. The present invention addresses these ongoing needs.

### BRIEF SUMMARY OF THE INVENTION

A CMP method suitable for polishing a tungsten-containing substrate is described. The method comprises abrading a surface of the substrate with a CMP polishing composition that comprises, consists essentially of, or consists of an aqueous carrier fluid containing (a) a polyamino compound; (b) at least one metal ion selected from a transition metal ion and a group IIIA/IVA metal ion; (c) a chelating agent, wherein the chelating agent comprises at least one compound selected from the group consisting ofmalonic acid, methylmalonic acid, ethylmalonic acid, phenylmalonic acid, and hydroxyethylidene-1,1-diphosphonic acid, and wherein the at least one metal ion and the chelating agent are present at a respective molar ratio of 0.5:1 to 2:1; (d) a particulate aluminum doped silica abrasive, wherein the aluminum doped silica abrasive is present in the composition, at point of use, at a concentration in the range of 0.05 to 3 percent by weight (wt%); (e) an oxidizing agent, and (f) optionally, an amino acid. These additives, when used in compositions as described herein, result in the reduction of tungsten recesses that occur when tungsten is polished according to general CMP processes.

Preferably, the particulate silica abrasive material is present in the composition, at point of use, at a concentration in the range of 0.1 to 1.5 wt%. The particulate silica abrasive material can be any silica abrasive material suitable for use in CMP compositions for polishing semiconductor materials, preferably colloidal silica.

In some embodiments, the polyamino compound comprises, consists essentially of, or consists of at least one poly(ethleneimine) compound, e.g., triethylenetetramine, tetraethylenepentamine, and pentaethylenehexamine. Preferably, the polyamino compound is present in the composition, at point of use, at a concentration in the range of 1 to 2000 parts-per-million (ppm) (e.g., 5 to 1000 ppm).

The metal ion is capable of cycling between multiple oxidation states, and preferably is present in the composition, at point of use, at a concentration in the range of 5 to 1000 ppm (e.g., 10 to 500 ppm).

The chelating agent may be DEQUEST 2010. Preferably, the chelating agent is present in the composition, at point of use, at a concentration in the range of 10 to 4000 ppm (e.g., 50 to 2000 ppm).

The oxidizing agent preferably is present in the composition, at point of use, at a concentration in the range of 0.1 to 10 percent by weight (e.g., 0.5 to 5 wt%). In some preferred embodiments, the oxidizing agent comprises, consists essentially of, or consists of hydrogen peroxide.

The polishing composition can optionally include an amino acid, e.g., at a concentration in the range of 500 ppm (0.05 wt%) to 3000 ppm (0.3 wt%). The amino acid can be any amino acid suitable for use as a corrosion inhibitor in CMP compositions. In some embodiments, the amino acid comprises, consists essentially of, or consists of glycine or lysine.

The CMP methods described herein preferably comprise the steps of abrading a surface of the substrate with a polishing pad and a CMP composition of the invention, and causing relative motion between the polishing pad and the substrate while maintaining a portion of the CMP composition in contact with the substrate surface between the pad and the substrate for a time period sufficient to remove at least a portion of the tungsten from the surface.

### BRIEF DESCRIPTION OF THE DRAWINGS

FIG. 1 provides a graph of tungsten recess depths obtained from polishing tungsten pattern wafers using a CMP composition described in Table 1 as Composition 6.
FIG. 2 provides a graph of tungsten recess depths obtained from polishing tungsten pattern wafers using a CMP composition described in Table 1 as Composition 7.

### DETAILED DESCRIPTION OF THE INVENTION

Methods for polishing a tungsten-containing substrate are described, which involve abrading a surface of a substrate with a CMP composition. In a preferred embodiment, the abrading is achieved by contacting a surface of a substrate with a polishing pad in the presence of the CMP composition between the pad and the substrate. The methods described herein allow tungsten layers to be removed or polished while reducing the amount of tungsten recessing that occurs. The CMP compositions used in the methods described herein comprise an aqueous carrier fluid containinga particulate silica abrasive, a polyamino compound, at least one metal ion selected from a transition metal ion and a group IIIA/IVA metal ion, a chelating agent, an oxidizing agent, and optionally, an amino acid. In particular the CMP compositions used in the methods described herein comprise an aqueous carrier containing: (a) a polyamino compound; (b) at least one metal ion selected from a transition metal ion and a group IIIA/IVA metal ion; (c) a chelating agent, wherein the chelating agent comprises at least one compound selected from the group consisting of malonic acid, methylmalonic acid, ethylmalonic acid, phenylmalonic acid, and hydroxyethylidene-1,1-diphosphonic acid,and wherein the at least one metal ion and the chelating agent are present at a respective molar ratio of 0.5:1 to 2:1; (d) a particulate aluminum doped silica abrasive, wherein the aluminum doped silica abrasive is present in the composition, at point of use, at a concentration in the range of 0.05 to 3 percent by weight (wt%); (e) an oxidizing agent; and (f) optionally, an amino acid.

Suitable polishing pads can be constructed or composed of any material, including solid, foam, woven or non-woven materials. The pad can include grooves if desired. Suitable polymeric materials for forming the pad include, for example, polyvinylchloride, polyvinylfluoride, nylon, fluorocarbon, polycarbonate, polyester, polyacrylate, polyether, polyethylene, polyamide, polyurethane, polystyrene, polypropylene, co-formed products thereof, and mixtures thereof.

Silica abrasive materials useful in the CMP methods described herein include any particulate silica abrasive material suitable for use in CMP of semiconductor materials. Colloidal silica is a preferred abrasive. The silica abrasive is present in the composition at concentration in the range of 0.05 to 3 percent by weight, e.g., 0.1 to 1.5 wt%. The abrasive particles preferably have a mean particle size in the range of 10 nm to 100 nm. Examples of such silica materials include silica having generally spherical shaped particles, silica having oblate or "cocoon shaped" particles, and the like. The silica comprises silica doped with aluminum, which is well known in the art.

The abrasive desirably is suspended in the CMP composition, more specifically in the aqueous component of the CMP composition. When the abrasive is suspended in the CMP composition, the abrasive preferably is colloidally stable. The term "colloid" refers to the suspension of abrasive particles in the liquid carrier. "Colloidal stability" refers to the maintenance of that suspension over time. In the context of this invention, an abrasive is considered colloidally stable if, when the abrasive is placed into a 100 ml graduated cylinder and allowed to stand without agitation for a time of 2 hours, the difference between the concentration of particles in the bottom 50 ml of the graduated cylinder ([B] in terms of g/ml) and the concentration of particles in the top 50 ml of the graduated cylinder ([T] in terms of g/ml) divided by the initial concentration of particles in the abrasive composition ([C] in terms of g/ml) is less than or equal to 0.5 (i.e., {[B] - [T]}/[C] ≤ 0.5). The value of [B]-[T]/[C] desirably is less than or equal to 0.3, and preferably is less than or equal to 0.1.

As used herein and in the appended claims the term "polyamino compound" encompasses compounds containing two or more amino groups that can be a primary amino group, a secondary amino group, a tertiary amino group, or any combination thereof. Examples of such polyamino compounds include 2-((2-((2-hydroxyethyl)amino)ethyl)amino)ethanol; N,N-bis(2-hydroxyethyl)ethylenediamine; 2- {[2-(dimethylamino)ethyl]methylamino}ethanol; 2,2-aminoethylaminoethanol; 2-(3-aminopropylamino)ethanol; 1-(2-hydroxyethyl)piperazine; 1,4-bis(2-hydroxyethyl)piperazine; choline; N-propylethylenediamine; a poly(ethyleneimine) compound, such as pentaethylenehexamine, tetraethylenepentamine, triethylenetetramine, and the like; and combinations of two or more thereof.

In a preferred embodiment, the CMP compositions used in the methods of the invention include polymeric polyamino compounds such as a poly(ethyleneimine) having the general formula such as H₂N-(CH₂CH₂NH)ₙ-CH₂CH₂-NH₂, where n is 2 or greater (e.g., n is 2, 3, 4, or 5), such as triethylenetetramine, tetraethylenepentamine, and pentaethylenehexamine. Preferred poly(ethyleneimine) compounds comprise 3 to 6 ethyleneimine groups per chain. Preferably, the CMP composition comprises 1 to 2000 ppm (e.g., 5 to 1000 ppm) of the polyamino compound.

As used herein, and as well understood in the art, the term "transition metal ion" refers to ions of metals in groups IIIB, IVB,VB, VIB, VIIB, VIIIB, IB, and IIB of the periodic table (also sometimes referred to as groups 3-12, with group VIIIB comprising groups 8, 9, and 10), and the term "group IIIA/IVA metal ion" refers to ions from groups IIIA (boron group; also referred to as group 13) and IVA (carbon group; also referred to as group 14) of the periodic table, as is well known in the art. The metal ion is capable of cycling between multiple oxidation states (e.g., Fe⁺³/Fe⁺²) during the polishing process. Non-limiting examples of such transition metal and group IIIA/IVA metal ions include, e.g., Ag, Co, Cr, Cu, Fe, Mo, Mn, Nb, Ni, Os, Pd, Ru, Ti, V, and Sn ions. In some embodiments, preferred metal ions are Ag, Cu or Fe ions. Fe ion (e.g., ferric ion) is particularly preferred. Typically the metal ion (e.g., ferric ion) is provided as a salt, e.g. ferric nitrate. In aqueous solution the metal ion typically is present as a hydrate or as a complex including one or more other ligands such as a halide, a hydroxide, or a chelating agent, in addition to or replacing water molecules of a hydrate. A preferred source of ferric ion is ferric nitrate (e.g., ferric nitrate nonahydrate). In the CMP compositions described herein, at least a portion, and in some embodiments, substantially all, of the transition metal ions and group IIIA/IVA metal ions in the composition are present as a complex with the chelating agent component of the composition. Preferably, the metal ion is present in the composition, at point of use, at a concentration in the range of 5 to 1000 ppm, e.g., 10 to 500 ppm.

As used herein and in the appended claims, the term "chelating agent" encompasses compounds including two or more carboxylic acid or phosphonic acid groups configured to interact with and bind or complex with the metal ion component of the composition.

The chelating agents comprise, of malonic acid; methylmalonic acid; ethylmalonic acid; phenylmalonic acid; and hydroxyethylidene-1,1-diphosphonic acid; salts of any of the foregoing; or a combination of two or more of the foregoing. Preferably, the chelating agent is present in the CMP compositions in an amount in the range of 10 to 4000 ppm, e.g., 50 to 2000 ppm. The molar ratio of metal ion-to-chelating agent is in the range of 0.5:1 to 2:1.

Oxidizing agents suitable for use in the CMP compositions and methods of the present invention include, without limitation, hydrogen peroxide, persulfate salts (e.g., ammonium monopersulfate; ammonium dipersulfate; potassium monopersulfate; and potassium dipersulfate); periodate salts (e.g., potassium periodate), salts thereof, and a combination of two or more of the foregoing. Hydrogen peroxide is a preferred oxidizing agent. Preferably, the oxidizing agent is present in the composition in an amount of 0.1 wt% to 10 wt% (e.g., 0.5 wt% to 5 wt%).

The CMP compositions described herein optionally can include one or more amino acids. Preferably, the amino acid is a corrosion inhibitor such as glycine, lysine, and the like, e.g., at a concentration in the range of 500 ppm to 3000 ppm.

Without wishing to be bound by theory, it is believed that in the CMP compositions described herein, the polyamino compounds act as a tungsten recess inhibitor and a corrosion inhibitor; the metal ion (e.g., ferric ion) acts as a tungsten removal rate catalyst; the chelating agent acts as a metal ion stabilizer; the amino acid acts as a tungsten corrosion inhibitor; and the particulate silica abrasive acts as a tungsten removal rate booster.

The CMP compositions described herein also, optionally, can include suitable amounts of one or more other additive materials commonly included in CMP compositions, such as viscosity modifying agents, biocides, and the like.

The aqueous carrier can be any aqueous solvent, e.g., water, aqueous methanol, aqueous ethanol, a combination thereof, and the like. Preferably, the aqueous carrier is or comprises deionized water.

The CMP compositions used in the methods of the invention preferably have an acidic pH (e.g. a pH of 2 to 4).

The CMP compositions used in the methods of the invention can be prepared by any suitable technique, many of which are known to those skilled in the art. The CMP compositions can be prepared in a batch or continuous process. Generally, the CMP compositions can be prepared by combining the components thereof in any order. The term "component" as used herein includes individual ingredients (e.g., abrasives, chelating agents, acids, bases, oxidizing agents, and the like), as well as any combination of ingredients. For example, an abrasive can be dispersed in water, and the chelating agent and the polyamino compound can be added, and mixed by any method that is capable of incorporating the components into the CMP composition. Typically, an oxidizing agent is not added to the CMP composition until the composition is ready for use in a CMP process, for example, the oxidizing agent can be added just prior to initiation of polishing. The pH can be adjusted at any suitable time.

The CMP compositions used in the methods of the present invention also can be provided as a concentrate, which is intended to be diluted with an appropriate amount of aqueous solvent (e.g., water) prior to use. In such an embodiment, the CMP composition concentrate can include the various components dispersed or dissolved in aqueous solvent in amounts such that, upon dilution of the concentrate with an appropriate amount of aqueous solvent, each component of the polishing composition will be present in the CMP composition in an amount within the appropriate range for use.

The CMP methods of the present invention are particularly suited for use in conjunction with a chemical-mechanical polishing apparatus. Typically, the CMP apparatus comprises a platen, which, when in use, is in motion and has a velocity that results from orbital, linear, and/or circular motion, a polishing pad in contact with the platen and moving relative to the platen when in motion, and a carrier that holds a substrate to be polished by contacting and moving relative to the surface of the polishing pad. The polishing of the substrate takes place by the substrate being placed in contact with the polishing pad and a CMP composition and then moving the polishing pad relative to the substrate, so as to abrade at least a portion of the substrate.

The following examples further illustrate various features and aspects of the compositions and methods described herein, but, of course, should not be construed as in any way limiting its scope. As used herein and in the following examples and claims, concentrations reported as ppm or as a percentage (wt%) are based on the weight of the active component of interest divided by the weight of the composition.

### EXAMPLE 1

Some non-limiting examples of CMP compositions useful for reducing tungsten recessing are illustrated below in Table 1. In the Table: The category captioned "Abrasive" lists the particulate silica abrasive used in the composition; "CS-A" stands for colloidal silica having a generally spherical particle shape and comprising some metal (Al, K) doping; "CS-B" stands for colloidal silica having a high purity and a generally oblate or cocoon shape. The silica particles, in each case have a mean particle size of 70 nm. The category captioned "Fe" lists the metal ion concentration, which in this case was ferric ion provided as ferric nitrate nonahydrate in the composition formulations. The category captioned "Chelating" lists the chelating agent used in the compositions; "MA" stands for malonic acid; "HD" stands for hydroxyethylidene-1,1-diphosphonic acid. The category captioned "AA" lists the amino acid used in the compositions: "G" stands for glycine. The caption "Polyamino" lists the polyamino compound used in the composition; "PEHA" stands for pentaethylenehexamine; "DETA" stands for diethylenetriamine; "TETA" stands for triethylenetetramine; "TEPA" stands for tetraethylenepentamine.

Three comparative samples lacking polyamino compounds were created, indicated in Table 1 as "Stand-A", "Stand-B", and "Stand-C." Concentrations in Table 1 are on a point of use basis.

**Table 1. Composition Formulations**

| Components | | | | | |
|---|---|---|---|---|---|
| Comp. # | Abrasive | Fe | Chelating | AA | Polyamino |
| Stand-A | CS-A, 0.25 wt% | 29 ppm | MA 445 ppm | 0 | 0 |
| Stand-B | CS-A, 0.25 wt% | 29 ppm | MA 445 ppm | G 1600 ppm | 0 |
| Stand-C | CS-A, 0.25 wt% | 29 ppm | HD 200 ppm | 0 | 0 |
| 1 | CS-A, 0.25 wt% | 29 ppm | MA 445 ppm | 0 | PEHA 400 ppm |
| 2 | CS-A, 0.25 wt% | 71 ppm | MA 890 ppm | 0 | DETA 400 ppm |
| 3 | CS-A, 0.25 wt% | 71 ppm | MA 890 ppm | G 1600 ppm | DETA 400 ppm |
| 4 | CS-A, 0.25 wt% | 71 ppm | MA 890 ppm | 0 | TETA 25 ppm |
| 5 | CS-B, 0.25 wt% | 29 ppm | MA 445 ppm | 0 | PEHA 100 ppm |
| 6 | CS-A, 0.75 wt% | 29 ppm | MA 445 ppm | 0 | PEHA 25 ppm |
| 7 | CS-A, 0.25 wt% | 29 ppm | MA 445 ppm | 0 | TEPA 25 ppm |
| 8 | CS-A, 0.25 wt% | 29 ppm | HD 200 ppm | 0 | PEHA 10 ppm |

### EXAMPLE 2

This example illustrates the performance of selected compositions for removal of tungsten from a substrate while minimizing the recess depth in the tungsten. Various compositions described in Table 1 were utilized to polish tungsten pattern wafers. The wafers included several pattern features including: Feature A - tungsten lines having a width of 0.18 µm and oxide spacer lines having a width of 0.18 µm between the tungsten lines; Feature B - tungsten lines having a width of 0.25 µm and oxide spacer lines having a width of 0.25 µm between the tungsten lines; Feature C - tungsten lines having a width of 1.5 µm and oxide spacer lines having a width of 0.5 µm between the tungsten lines; Feature D - tungsten lines having a width of 2 µm and oxide spacer lines having a width of 2 µm between the tungsten lines; and Feature E - tungsten lines having a width of 3 µm and oxide spacer lines having a width of 7µm between the tungsten lines.

The tungsten pattern wafers were polished using a bench-top polishing machine under the following polishing conditions: an APPLIED MATERIALS MIRRA device using a rigid microporous polyurethane polishing pad with radial grooving, down-force of 2.5 psi, platen speed of 113 rpm, carrier speed of 117 rpm, and a slurry feed rate of 150 mL/min. The tungsten recess depths after polishing with the various compositions of Example 1 were measured by scanning probe microscopy (VEECO DIMENSION 3100) and are provided in Table 2. Recess depths are indicated in angstroms (Å).

**Table 2. Tungsten Recess Depths**

| Composition | Feature A Recess Depth (Å) | Feature B Recess Depth (Å) | Feature C Recess Depth (Å) | Feature D Recess Depth (Å) | Feature E Recess Depth (Å) |
|---|---|---|---|---|---|
| Stand-A | 209 | 224 | 303 | 400 | 398 |
| Stand-B | 133 | 132 | 192 | 356 | 405 |
| Stand-C | 145 | 148 | 847 | 1815 | 1898 |
| 1 | 32 | 53 | 149 | 187 | 243 |
| 2 | 35 | 21 | 46 | 192 | 271 |
| 3 | 65 | 45 | 43 | 221 | 227 |
| 4 | 51 | 78 | 128 | 105 | 221 |
| 5 | 42 | 45 | 58 | 138 | 195 |
| 6 | 37 | 41 | 40 | 48 | 142 |
| 7 | 79 | 88 | 142 | 232 | 258 |
| 8 | 78 | 89 | 63 | 280 | 338 |

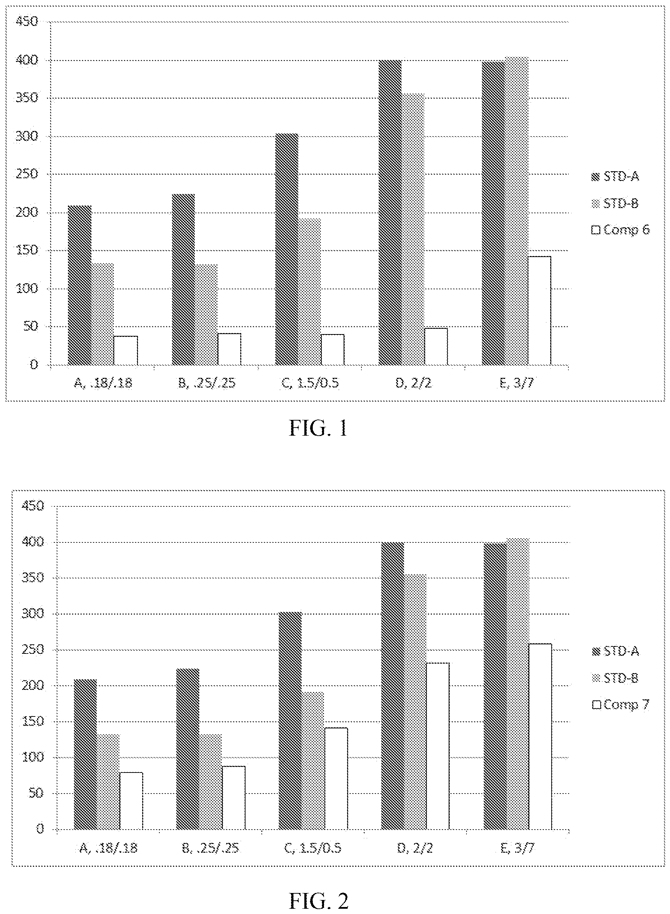

Representative samples of the tungsten recess depth results from Table 2 are plotted in FIG. 1 and FIG. 2. FIG. 1 shows the tungsten recess depth obtained by polishing with Composition 6. FIG. 2 shows the tungsten recess depth obtained by polishing with Composition 7. The tungsten recess depth obtained by polishing with STAND-A and STAND-B are also included in FIGs. 1 and 2 for comparative purposes. Removal rates for Compositions 6 and 7 were in the range of 600 to 800 Å/min.

Composition 6 is identical to Composition 7 except that Composition 6 contains pentaethylenehexamine and Composition 7 contains tetraethylenepentamine as the polyamino compound. Composition 6 also contains three times as much abrasive as Composition 7. Even though Composition 6 contains a higher concentration of abrasive, the tungsten recess depth for Composition 6 is less than the recess depth of Composition 7 for each one of the wafers polished. Therefore, the use of a pentaethylenehexamine is advantageous for reduction in tungsten recessing, at least when compared to the use of tetraethylenepentamine.

In all cases, the compositions reduced the size of tungsten recesses that occur upon polishing compared to the comparative examples of Standard A, Standard B, and Standard C.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

## Claims

1. A chemical-mechanical polishing (CMP) method for polishing a tungsten-containing substrate comprising abrading a surface of the substrate with a CMP composition comprising an aqueous carrier containing:
(a) a polyamino compound;
(b) at least one metal ion selected from a transition metal ion and a group IIIA/IVA metal ion;
(c) a chelating agent, wherein the chelating agent comprises at least one compound selected from the group consisting of malonic acid, methylmalonic acid, ethylmalonic acid, phenylmalonic acid, and hydroxyethylidene-1,1-diphosphonic acid, and wherein the at least one metal ion and the chelating agent are present at a respective molar ratio of 0.5:1 to 2:1;
(d) a particulate aluminum doped silica abrasive, wherein the aluminum doped silica abrasive is present in the composition, at point of use, at a concentration in the range of 0.05 to 3 percent by weight (wt%);
(e) an oxidizing agent; and
(f) optionally, an amino acid.

2. The method of claim 1 wherein the polyamino compound comprises at least one poly(ethyleneimine) compound; or
the polyamino compound comprises a compound of formula H₂N-(CH₂CH₂NH)ₙ-CH₂CH₂-NH₂, wherein n is 2, 3, 4, or 5.

3. The method of claim 1 wherein the silica abrasive comprises colloidal silica.

4. The method of claim 1 wherein the composition comprises at least one amino acid selected from the group consisting of glycine and lysine.

5. The method of claim 1 wherein the metal ion comprises ferric ion.

6. The method of claim 1 wherein the oxidizing agent comprises hydrogen peroxide.

7. The method of claim 1 wherein the polyamino compound is present in the composition, at point of use, at a concentration in the range of 1 to 2000 parts-per-million (ppm).

8. The method of claim 1 wherein the metal ion is present in the composition, at point of use, at a concentration in the range of 5 to 1000 ppm.

9. The method of claim 1 wherein the chelating agent is present in the composition, at point of use, at a concentration in the range of 10 to 4000 ppm.

10. The method of claim 1 wherein the composition comprises 500 ppm to 3000 ppm of the amino acid,
wherein optionally the oxidizing agent is present at a concentration in the range of 0.1 to 10 wt%.

11. The chemical-mechanical polishing (CMP) method of claim 1 comprising an aqueous carrier containing, at point of use:
(a) 1 to 2000 ppm of a polyamino compound;
(b) 5 to 1000 ppm of ferric ion;
(c) 10 to 4000 ppm of a chelating agent;
(d) 0.05 to 3 wt% of a particulate aluminum doped silica abrasive;
(e) 0.1 to 10% of hydrogen peroxide; and
(f) optionally, 500 to 3000 ppm of an amino acid.

12. The method of claim 11 wherein any one or more of the following applies,
a) the polyamino compound comprises at least one a poly(ethyleneimine) compound;
b) the polyamino compound comprises a compound of formula H₂N-(CH₂CH₂NH)ₙ-CH₂CH₂-NH₂, wherein N is 2, 3, 4, or 5;
c) the ferric ion and the chelating agent are present at a respective molar ratio of 0.5:1 to 2:1.

13. The method of claim 11 wherein the chelating agent comprises at least one compound selected from the group consisting of malonic acid, methylmalonic acid, ethylmalonic acid, phenylmalonic acid, and hydroxyethylidene-1,1-diphosphonic acid;

14. The method of claim 11 wherein the silica abrasive comprises colloidal silica; and

15. The method of claim 11 wherein the composition comprises 500 to 3000 ppm of glycine.

## Patentansprüche

1. Verfahren zum chemisch-mechanischen Polieren (CMP) zum Polieren eines wolframhaltigen Substrats, umfassend das Abschleifen einer Oberfläche des Substrats mit einer CMP-Zusammensetzung, die einen wässrigen Träger umfasst, der
(a) eine Polyaminoverbindung;
(b) mindestens ein Metallion, das aus einem Übergangsmetallion und einem Metallion der Gruppe IIIA/IVA ausgewählt ist;
(c) einen Chelatbildner, wobei der Chelatbildner mindestens eine Verbindung aus der Gruppe bestehend aus Malonsäure, Methylmalonsäure, Ethylmalonsäure, Phenylmalonsäure und Hydroxyethyliden-1,1-diphosphonsäure umfasst und wobei das mindestens eine Metallion und der Chelatbildner in einem jeweiligen Molverhältnis von 0,5:1 bis 2:1 vorliegen;
(d) ein partikuläres Schleifmittel auf Basis von aluminiumdotiertem Siliciumdioxid, wobei das Schleifmittel auf Basis von aluminiumdotiertem Siliciumdioxid zum Zeitpunkt der Verwendung in einer Konzentration im Bereich von 0,05 bis 3 Gewichtsprozent (Gew.-%) in der Zusammensetzung vorliegt;
(e) ein Oxidationsmittel und
(f) gegebenenfalls eine Aminosäure
enthält.

2. Verfahren nach Anspruch 1, wobei die Polyaminoverbindung mindestens eine Poly(ethylenimin)verbindung umfasst oder die Polyaminoverbindung eine Verbindung der Formel H₂N-(CH₂CH₂NH)ₙ-CH₂CH₂-NH₂ umfasst, wobei n 2, 3, 4 oder 5 ist.

3. Verfahren nach Anspruch 1, wobei das Schleifmittel auf Basis von Siliciumdioxid kolloidales Siliciumdioxid umfasst.

4. Verfahren nach Anspruch 1, wobei die Zusammensetzung mindestens eine Aminosäure aus der Gruppe bestehend aus Glycin und Lysin umfasst.

5. Verfahren nach Anspruch 1, wobei das Metallion Eisen(III) umfasst.

6. Verfahren nach Anspruch 1, wobei das Oxidationsmittel Wasserstoffperoxid umfasst.

7. Verfahren nach Anspruch 1, wobei die Polyaminoverbindung zum Zeitpunkt der Verwendung in einer Konzentration im Bereich von 1 bis 2000 Teillen pro Million (ppm) in der Zusammensetzung vorliegt.

8. Verfahren nach Anspruch 1, wobei das Metallion zum Zeitpunkt der Verwendung in einer Konzentration im Bereich von 5 bis 1000 ppm in der Zusammensetzung vorliegt.

9. Verfahren nach Anspruch 1, wobei der Chelatbildner zum Zeitpunkt der Verwendung in einer Konzentration im Bereich von 10 bis 4000 ppm in der Zusammensetzung vorliegt.

10. Verfahren nach Anspruch 1, wobei die Zusammensetzung 500 ppm bis 3000 ppm der Aminosäure umfasst, wobei das Oxidationsmittel gegebenenfalls in einer Konzentration im Bereich von 0,1 bis 10 Gew.-% vorliegt.

11. Verfahren zum chemisch-mechanischen Polieren (CMP) nach Anspruch 1, umfassend einen wässrigen Träger, der zum Zeitpunkt der Verwendung:
(a) 1 bis 2000 ppm einer Polyaminoverbindung;
(b) 5 bis 1000 ppm Eisen(III);
(c) 10 bis 4000 ppm eines Chelatbildners;
(d) 0,05 bis 3 Gew.-% eines partikulären Schleifmittels auf Basis von aluminiumdotiertemn Siliciumdioxid;
(e) 0,1 bis 10 % Wasserstoffperoxid und
(f) gegebenenfalls 500 bis 3000 ppm einer Aminosäure
enthält.

12. Verfahren nach Anspruch 11, wobei eine oder mehrere der folgenden Aussagen zutreffen:
a) die Polyaminoverbindung umfasst mindestens eine Poly(ethylenimin)verbindung;
b) die Polyaminoverbindung umfasst eine Verbindung der Formel H₂N-(CH₂CH₂NH)ₙ-CH₂CH₂-NH₂, wobei n 2, 3, 4 oder 5 ist;
c) das Eisen(III) und der Chelatbildner liegen in einem jeweiligen Molverhältnis von 0,5:1 bis 2:1 vor.

13. Verfahren nach Anspruch 11, wobei der Chelatbildner mindestens eine Verbindung aus der Gruppe bestehend aus Malonsäure, Methylmalonsäure, Ethylmalonsäure, Phenylmalonsäure und Hydroxyethyliden-1,1-diphosphonsäure umfasst.

14. Verfahren nach Anspruch 11, wobei das Schleifmittel auf Basis von Siliciumdioxid kolloidales Siliciumdioxid umfasst.

15. Verfahren nach Anspruch 11, wobei die Zusammensetzung 500 bis 3000 ppm Glycin umfasst.

## Revendications

1. Procédé de polissage chimique-mécanique (CMP) pour le polissage d'un substrat contenant du tungstène, comprenant l'abrasion d'une surface du substrat avec une composition de CMP comprenant un véhicule aqueux contenant :
(a) un composé polyamino ;
(b) au moins un ion de métal sélectionné parmi un ion de métal de transition et un ion de métal du groupe IIIA/IVA ;
(c) un agent chélatant, l'agent chélatant comprenant au moins un composé sélectionné dans le groupe constitué de l'acide malonique, de l'acide méthylmalonique, de l'acide éthylmalonique, de l'acide phénylmalonique, et de l'acide hydroxyéthylidène-1,1-diphosphonique, et ledit au moins un ion de métal et l'agent chélatant étant présents selon un rapport molaire respectif de 0,5:1 à 2:1 ;
(d) un abrasif de type silice dopé à l'aluminium particulaire, l'abrasif de type silice dopé à l'aluminium étant présent dans la composition, au point d'utilisation, à une concentration de 0,05 à 3 % en poids (%pds) ;
(e) un agent oxydant, et
(f) optionnellement, un acide aminé.

2. Procédé selon la revendication 1, dans lequel le composé polyamino comprend au moins un composé poly(éthylèneimine) ; ou
le composé polyamino comprend un composé ayant la formule H₂N-(CH₂CH₂NH)ₙ-CH₂CH₂-NH₂, dans laquelle n vaut 2, 3, 4, ou 5.

3. Procédé selon la revendication 1, dans lequel l'abrasif de type silice comprend de la silice colloïdale.

4. Procédé selon la revendication 1, dans lequel la composition comprend au moins un acide aminé sélectionné dans le groupe constitué de la glycine et de la lysine.

5. Procédé selon la revendication 1, dans lequel l'ion de métal comprend un ion ferrique.

6. Procédé selon la revendication 1, dans lequel l'agent oxydant comprend le peroxyde d'hydrogène.

7. Procédé selon la revendication 1, dans lequel le composé polyamino est présent dans la composition, au point d'utilisation, à une concentration de 1 à 2 000 parties par million (ppm).

8. Procédé selon la revendication 1, dans lequel l'ion de métal est présent dans la composition, au point d'utilisation, à une concentration de 5 à 1 000 ppm.

9. Procédé selon la revendication 1, dans lequel l'agent chélatant est présent dans la composition, au point d'utilisation, à une concentration de 10 à 4 000 ppm.

10. Procédé selon la revendication 1, dans lequel la composition comprend 500 ppm à 3 000 ppm de l'acide aminé,
dans lequel, optionnellement, l'agent oxydant est présent à une concentration de 0,1 à 10 %pds.

11. Procédé de polissage chimique-mécanique (CMP) selon la revendication 1, comprenant un véhicule aqueux contenant, au point d'utilisation :
(a) 1 à 2 000 ppm d'un composé polyamino ;
(b) 5 à 1 000 ppm d'un ion ferrique ;
(c) 10 à 4 000 ppm d'un agent chélatant ;
(d) 0,05 à 3 %pds d'un abrasif de type silice dopé à l'aluminium particulaire ;
(e) 0,1 à 10 % de peroxyde d'hydrogène ; et
(f) optionnellement, 500 à 3 000 ppm d'un acide aminé.

12. Procédé selon la revendication 11, dans lequel une ou plusieurs des conditions suivantes s'appliquent :
a) le composé polyamino comprend au moins un composé poly(éthylèneimine) ;
b) le composé polyamino comprend un composé ayant la formule H₂N-(CH₂CH₂NH)ₙ-CH₂CH₂-NH₂, dans laquelle n vaut 2, 3, 4, ou 5 ;
c) l'ion ferrique et l'agent chélatant sont présents selon un rapport molaire respectif de 0,5:1 à 2:1.

13. Procédé selon la revendication 11, dans lequel l'agent chélatant comprend au moins un composé sélectionné dans le groupe constitué de l'acide malonique, de l'acide méthylmalonique, de l'acide éthylmalonique, de l'acide phénylmalonique, et de l'acide hydroxyéthylidène-1,1-diphosphonique.

14. Procédé selon la revendication 11, dans lequel l'abrasif de type silice comprend de la silice colloïdale.

15. Procédé selon la revendication 11, dans lequel la composition comprend 500 à 3 000 ppm de glycine.
